# EUROPEAN PATENT APPLICATION

(11) **EP 4 368 742 A1**
(43) Date of publication of application: **15.05.2024**
(21) Application number: 23207889.9
(22) Date of filing: 06.11.2023
(51) Int. Cl.: C23C 14/32, C23C 14/56, H01J 37/32, H05H 1/48, H05H 1/50

(54) **ARC EVAPORATION SOURCE**

(30) Priority: 07.11.2022 JP 2022178434
(71) Applicant: KABUSHIKI KAISHA KOBE SEIKO SHO (KOBE STEEL, LTD.), Hyogo 651-8585 (JP)
(72) Inventor: TAKAHASHI, Tetsuya, Takasago-shi, 676-8670 (JP); FUJITA, Junki, Takasago-shi, 676-8670 (JP); KUJIME, Susumu, Takasago-shi, 676-8670 (JP); YAMAMOTO, Kenji, Kobe-shi, 651-2271 (JP)
(74) Representative: TBK

(57) **Abstract**

An arc evaporation source includes a target including a target discharge surface, an arc power supply, an electromagnetic coil arranged forward of the target, and a central magnet arranged rearward of the target. The electromagnetic coil forms a first magnetic field containing a first magnetic force line intersecting the target discharge surface and extending so as to pass through, in a front-rear direction, radially inside the electromagnetic coil. The central magnet forms a second magnetic field containing a second magnetic force line extending in a front-rear direction in a region between the central magnet and the target discharge surface. Repulsion between the first magnetic field and the second magnetic field stably forms a horizontal magnetic field and a vertical magnetic field on the target discharge surface.

## Description

### Field of the Invention

The present invention relates to an arc evaporation source.

### Background Art

Conventionally, various film formation methods using arc discharge have been proposed as a method for forming a film on a surface of a base material such as a tool or a mechanical component for the purpose of improving wear resistance. Japanese Patent Application Laid-Open No. H10-280135 discloses a thin coating vapor depositing device using such arc discharge. In the device, an arc regulator including a permanent magnet or an electromagnet is arranged each forward and rearward of a target. A vacuum chamber constitutes an anode in the arc discharge, a holder supporting the target constitutes a cathode in the arc discharge, and an arc discharge voltage is applied between both electrodes. Then, each arc regulator forms a magnetic force line directed from the target to a workpiece (vapor deposition object, film forming target), whereby charged particles of the vapor deposition substance emitted from a target discharge surface upon receiving the arc discharge fly toward the workpiece and are deposited.

In the technique described in Japanese Patent Application Laid-Open No. H10-280135, since an arc spot is less likely to move on a target discharge surface, macroparticles (also called droplets), which are a mass of film forming material, are likely to be generated, and there has been a problem that surface roughness of a coating film on a workpiece is deteriorated by adhesion of such macroparticles to the workpiece. Specifically, in the above technique, magnetic force lines are formed such that a permanent magnet or an electromagnet arranged around the target pass through the target discharge surface in a same orientation in a direction perpendicular to the target discharge surface. In this case, while a strong vertical magnetic field is formed on the target discharge surface, a horizontal magnetic field is hardly formed, and thus the arc spot becomes less likely to move on the target discharge surface. Therefore, the arc spot is likely to remain at the same position on the target discharge surface, and the film forming material having a high temperature is likely to be emitted as macroparticles.

### Summary of the Invention

An object of the present invention is to provide an arc evaporation source that can suppress generation of macroparticles flying toward a workpiece by promoting movement of an arc spot on a target discharge surface.

Provided by the present invention is an arc evaporation source that evaporates a film forming material by arc discharge and supplies the film forming material to a workpiece. The arc evaporation source includes a target, an anode, an arc power supply, an electromagnetic coil, and a central magnet. The target includes a target discharge surface arranged rearward of the workpiece and facing the workpiece, the target discharge surface emitting the film forming material forward upon receiving arc discharge. The anode is arranged forward of the target and generates the arc discharge. The arc power supply applies, between the target and the anode, a discharge voltage for generating the arc discharge. The electromagnetic coil is a cylindrical electromagnetic coil arranged forward of the target discharge surface and having a center line orthogonal to the target discharge surface. The electromagnetic coil forms a first magnetic field. The first magnetic field contains a first magnetic force line extending so as to pass through, in a front-rear direction, a cylindrical space intersecting the target discharge surface and surrounded by the electromagnetic coil. The central magnet is arranged on the center line rearward of the target discharge surface so as to form a second magnetic field. The second magnetic field contains a second magnetic force line extending in a front-rear direction in a region held between the central magnet and the target discharge surface in the front-rear direction. The central magnet forms the second magnetic field such that a component of the second magnetic force line parallel to the center line is in a reverse orientation to a component of the first magnetic force line parallel to the center line.

### Brief Description of the Drawings

Fig. 1 is a schematic horizontal cross-sectional view of a film forming device including an arc evaporation source according to an embodiment of the present invention.
Fig. 2 is a side cross-sectional view of an arc evaporation source according to an embodiment of the present invention.
Fig. 3 is an enlarged side cross-sectional view of an arc evaporation source according to an embodiment of the present invention.
Fig. 4 is a schematic horizontal cross-sectional view of a film forming device including an arc evaporation source according to a modified embodiment of the present invention.
Fig. 5 is a view illustrating a magnetic field distribution around a target in Example 1 of the present invention.
Fig. 6 is a view illustrating a magnetic field distribution around a target in Example 2 of the present invention.
Fig. 7 is a view illustrating a magnetic field distribution around a target in Example 3 of the present invention.
Fig. 8 is a view illustrating a magnetic field distribution around a target in Example 4 of the present invention.
Fig. 9 is a view illustrating a magnetic field distribution around a target in Example 5 of the present invention.
Fig. 10 is a view illustrating a magnetic field distribution around a target in Comparative Example 1 of the present invention.
Fig. 11 is a view illustrating a magnetic field distribution around a target in Comparative Example 2 of the present invention.
Fig. 12 is a view illustrating a magnetic field distribution around a target in Comparative Example 3 of the present invention.

### Description of Embodiements

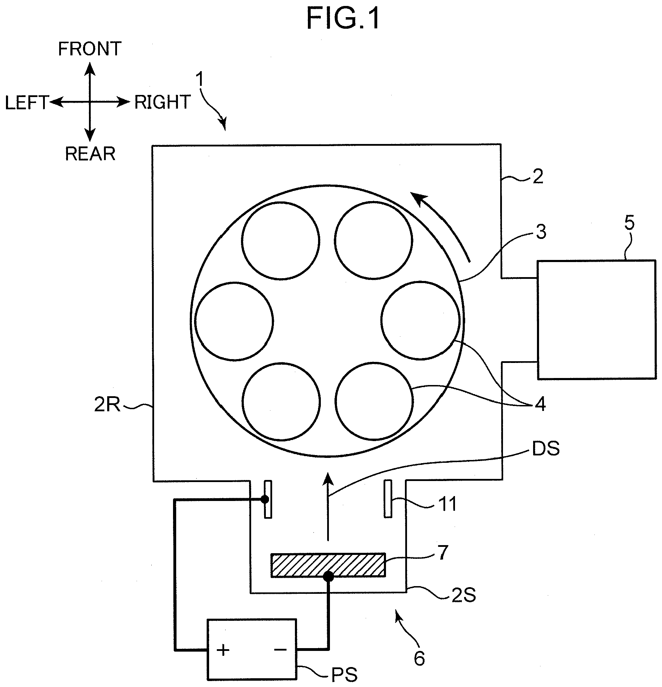

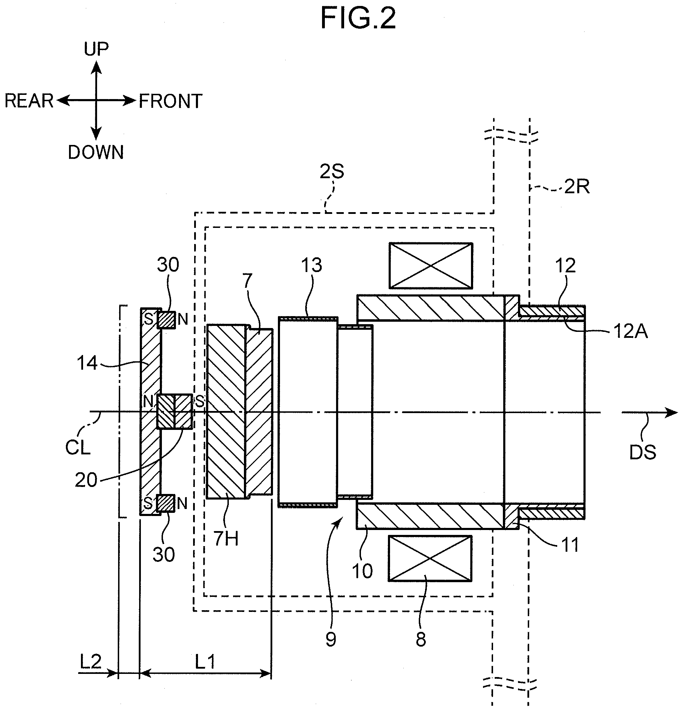

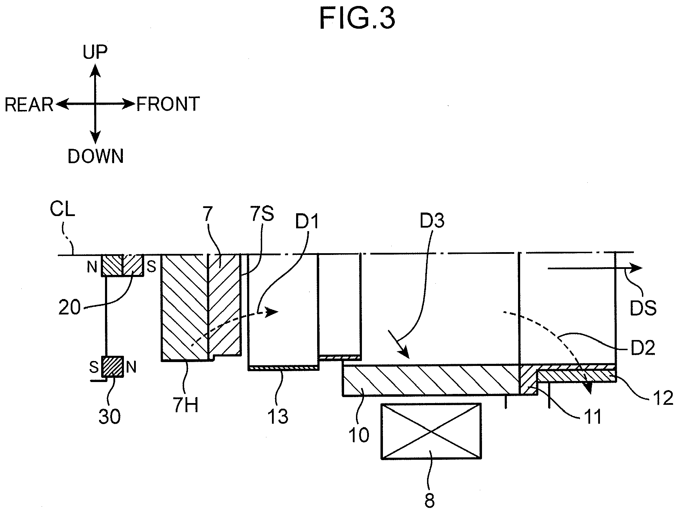

Hereinafter, a film forming device 1 including an arc evaporation source according to an embodiment of the present invention will be described with reference to the drawings. Fig. 1 is a schematic horizontal cross-sectional view of the film forming device 1 including an arc evaporation source 6 according to the present embodiment. Fig. 2 is a side cross-sectional view of the arc evaporation source 6 according to the present embodiment, and is a cross-sectional view in the up-down direction and the front-rear direction including a center line CL. Fig. 3 is an enlarged side cross-sectional view of the arc evaporation source 6 according to the present embodiment, and illustrates only a part downward the center line CL. The directions illustrated in the drawings are for describing the structures and functions of the arc evaporation source 6 and the film forming device 1 according to the present embodiment, and do not limit the arc evaporation source according to the present invention. That is, the arc evaporation source 6 illustrated in each drawing may be arranged so as to have a different attitude with respect to the horizontal direction and the vertical direction. Regarding the front-rear direction in each drawing, a direction from a target 7 toward a workpiece 4 is defined as a front direction, and the opposite direction is defined as a rear direction, and a horizontal direction orthogonal to the front-rear direction and the up-down direction (vertical direction) is defined as a left-right direction.

The film forming device 1 forms a film (e.g., a nitride film) on the workpiece 4 (base material) by cathode arc discharge. The material of the film is not limited to the above. The film forming device 1 includes a vacuum chamber 2, a rotary table 3, a plurality of workpieces 4, a vacuum pump 5, and the arc evaporation source 6.

The vacuum chamber 2 has a wall part surrounding an internal space, and the vacuum pump 5 brings the internal space into a vacuum state. The arc discharge is generated inside the vacuum chamber 2. The rotary table 3, the plurality of workpieces 4, the target 7, and the like are accommodated in the internal space. The vacuum chamber 2 is made of a conductive metal material, and is made of stainless steel (SUS) in the present embodiment. The vacuum chamber 2 includes a chamber body 2R having a substantially cuboid shape and having a body space for accommodating the workpiece 4, and a chamber tube part 2S (chamber tubular part) having a tubular space communicating with a body space of the chamber body 2R.

The chamber tube part 2S accommodates at least the target 7, is connected to the chamber body 2R so as to extend tubularly about the center line CL (Fig. 2), and accommodates the target 7 in a tubular space thereof. The chamber tube part 2S may be detachable from the chamber body 2R. The shape of the chamber tube part 2S is not limited to the tubular shape as described above.

The rotary table 3 is arranged in the chamber body 2R of the vacuum chamber 2. The rotary table 3 has an upper surface part on which the plurality of workpieces 4 can be placed, and is rotated about a rotation center axis extending in the up-down direction by a drive mechanism not illustrated as indicated by an arrow in Fig. 1. In the present embodiment, as illustrated in Fig. 1, the plurality of workpieces 4 are arranged on the upper surface part of the rotary table 3 at predetermined intervals along the rotation direction. As an example, each of the workpieces 4 includes a rotation jig rotatable about the rotation center axis extending in the up-down direction, and a plurality of drill blades mounted on the rotation jig.

The arc evaporation source 6 evaporates a film forming material by arc discharge, and supplies the workpiece 4 with the film forming material. The arc evaporation source 6 includes the target 7 containing a film forming material, a back plate 7H, an anode for generating arc discharge, an electromagnetic coil 8, an arc power supply PS, a duct 9 (a main duct 10, a tip end duct 11, a magnetic body 12, and an introduction duct 13), a yoke plate 14, a central magnet 20, and an outer magnet 30. As the film forming material, the target 7 may be a material made mostly from metal or a material made mostly from carbon and is not particularly limited.

The target 7 includes a target discharge surface 7S (Fig. 3) arranged rearward of the workpiece 4 and facing the workpiece 4, the target discharge surface 7S emitting the film forming material forward upon receiving the arc discharge. In the present embodiment, the target 7 has a flat columnar shape, and the target discharge surface 7S corresponds to a front end surface of the target 7. The target discharge surface 7S has a circular shape having the center line CL extending in the front-rear direction. In Figs. 2 and 3, a direction in which metal ions as a film forming material are supplied toward the workpiece 4 is indicated by an arrow DS.

The back plate 7H is a cylindrical member supporting the target 7 from rearward. The back plate 7H is made of a conductor and is electrically connected to the target 7.

The electromagnetic coil 8 is a cylindrical electromagnetic coil arranged forward of the target discharge surface 7S and having the center line CL orthogonal to the target discharge surface 7S. Specifically, the electromagnetic coil 8 is configured by winding a coil wire not illustrated a plurality of times around the center line CL. By receiving a current from a power supply not illustrated, the electromagnetic coil 8 can form the first magnetic field containing the first magnetic force line that intersects the target discharge surface 7S and extends so as to pass through in the front-rear direction a cylindrical space surrounded by the electromagnetic coil 8. The first magnetic field will be described later in detail.

The arc power supply PS includes a negative electrode connected to the target 7 and a positive electrode connected to the anode, and applies, between the target 7 and the tip end duct 11 or the like, a discharge voltage for generating arc discharge. As a result, the target 7 functions as a cathode in arc discharge.

The duct 9 is arranged forward of the target discharge surface 7S and radially inside relative to the electromagnetic coil 8, and has a cylindrical shape about the center line CL. The duct 9 includes the main duct 10, the tip end duct 11, the magnetic body 12 (magnetic duct), and the introduction duct 13. The duct 9 has a cylindrical duct internal space that internally receives the film forming material emitted from the target discharge surface 7S and allows the film forming material to pass through toward the workpiece 4. As illustrated in Fig. 2, the duct 9 is arranged between the target 7 and the workpiece 4 so as to straddle the tubular space of the chamber tube part 2S and the body space of the chamber body 2R.

The main duct 10 is made of a conductive nonmagnetic material, is arranged forward of the target discharge surface 7S and radially inside relative to the electromagnetic coil 8, and has a cylindrical shape about the center line CL. The main duct 10 has an outer peripheral surface arranged at an interval in the radial direction from an inner peripheral surface of the electromagnetic coil 8. The main duct 10 is arranged such that a center part in the front-rear direction faces the electromagnetic coil 8 in the radial direction, and the length of the main duct 10 in the front-rear direction is set longer than the length of the electromagnetic coil 8. In other words, the electromagnetic coil 8 is arranged radially outside the main duct 10. The inner diameter of the main duct 10 is set slightly larger than the outer diameter of the target 7. The main duct 10 is connected to the magnetic body 12 so as to be conductive to each other, and constitutes a part of the anode. As an example, the main duct 10 is made of SUS. The main duct 10 is insulated from the vacuum chamber 2.

The tip end duct 11 is arranged forward of the main duct 10 and is connected to the main duct 10 in a conductive manner. The tip end duct 11 has a cylindrical shape about the center line CL, and the inner peripheral surface of the tip end duct 11 is continuous with the inner peripheral surface of the main duct 10. In the present embodiment, the inner peripheral surfaces are flush with each other, but the present invention is not limited to this. The inner diameter of the tip end duct 11 may be larger than the inner diameter of the main duct 10. An outer peripheral surface of the tip end duct 11 supports the magnetic body 12. As an example, the tip end duct 11 is made of SUS. As mentioned earlier, a positive electrode of the arc power supply PS is connected to the tip end duct 11 (Fig. 1). The tip end duct 11 is insulated from the vacuum chamber 2.

The magnetic body 12 is made of a conductive magnetic material, is arranged forward of the electromagnetic coil 8, that is, at a position close to the workpiece 4 relative to the electromagnetic coil 8, and has a cylindrical shape about the center line CL. As described above, the magnetic body 12 is supported (fixed) on the outer peripheral surface of the tip end duct 11. In the present embodiment, the magnetic body 12 is made of iron. The magnetic body 12 is desirably a metal magnetic body excluding an insulating magnetic body such as ferrite in order to have conductivity. The magnetic body 12 is connected to the tip end duct 11 so as to be conductive to each other, and constitutes a part of the anode. The magnetic body 12 has a magnetic inner peripheral surface 12A (Fig. 2) arranged radially inside relative to the electromagnetic coil 8 when viewed from a direction parallel to the center line CL and surrounding the duct internal space. That is, the magnetic body 12 includes a magnetic inner peripheral surface having the inner diameter smaller than the inner diameter of the electromagnetic coil 8 and surrounding the duct internal space. The inner diameter of this magnetic inner peripheral surface 12A is set larger than the outer diameter of the target discharge surface 7S. As illustrated in Fig. 2, the magnetic body 12 is arranged inside the chamber body 2R. The magnetic body 12 has a function of attracting, by its magnetic characteristics, a magnetic field (magnetic force line) formed by the electromagnetic coil 8. In other words, the magnetic force line formed by the electromagnetic coil 8 is curved radially outward so as to pass through (cross) the magnetic body 12 forward of the electromagnetic coil 8.

The introduction duct 13 is arranged between the target discharge surface 7S and the main duct 10 in the front-rear direction, and has a cylindrical shape about the center line CL. The introduction duct 13 introduces, into the main duct 10, the film forming material emitted from the target discharge surface 7S. In the present embodiment, as illustrated in Fig. 2, the introduction duct 13 has a two-step structure having different outer diameters, and the inner diameter and the outer diameter of a front part of the introduction duct 13 are set smaller than the inner diameter and the outer diameter of a rear part of the introduction duct 13. Furthermore, the introduction duct 13 has a front end part arranged to enter the inside of the main duct 10. The inner diameter of a rear end part of the introduction duct 13 is set larger than the outer diameter of the target discharge surface 7S. Thus, the metal ions emitted from the target discharge surface 7S can reliably enter the inside of the main duct 10. The introduction duct 13 may have the same inner diameter and outer diameter along the front-rear direction (axial direction). The introduction duct 13 is electrically insulated from the target 7, the main duct 10, and the tip end duct 11. As an example, the introduction duct 13 is made of SUS, but may be made of an insulating material.

The yoke plate 14 is arranged rearward of the target 7 at an interval and has a disk shape about the center line CL. The central magnet 20 and the outer magnet 30 are fixed to a front surface part of the yoke plate 14.

The central magnet 20 is arranged on the center line CL rearward of the target discharge surface 7S (target 7). The central magnet 20 is a permanent magnet having a columnar shape, and in the present embodiment, as illustrated in Figs. 2 and 3, an S pole is arranged on a front part of the central magnet 20, and an N pole is arranged on a rear part of the central magnet 20. The central magnet 20 can form the second magnetic field containing the second magnetic force line extending in the front-rear direction in a region held between the central magnet 20 and the target discharge surface 7S from the front and the rear. The second magnetic field will also be described in detail later.

The outer magnet 30 is annularly arranged about the center line CL radially outside the central magnet 20 so as to surround the central magnet 20 rearward of the target discharge surface 7S. In the present embodiment, a plurality of permanent magnets are annularly arranged at intervals from each other around the center line CL. Each permanent magnet has a columnar shape, and in the present embodiment, as illustrated in Figs. 2 and 3, an N pole is arranged in a front part of the outer magnet 30, and an S pole is arranged in a rear part of the outer magnet 30. The outer magnet 30 may be a ring-shaped permanent magnet about the center line CL, or a mode in which a plurality of magnetic poles are magnetized in a ring-shaped magnetic body may be adopted, but arranging the plurality of permanent magnets in an annular shape as described above can reduce the cost of the arc evaporation source 6. The outer magnet 30 forms a closed magnetic field between the outer magnet 30 and the central magnet 20. In particular, the outer magnet 30 can form a third magnetic field containing a third magnetic force line extending in the front-rear direction in a region forward of the outer magnet 30 and rearward of the target discharge surface 7S. The third magnetic field will also be described in detail later.

The yoke plate 14, the central magnet 20, and the outer magnet 30 constitute a magnet unit in the arc evaporation source 6. In the present embodiment, as illustrated in Fig. 2, the central magnet 20 and the outer magnet 30 supported by the yoke plate 14 are arranged under the atmospheric pressure outside the chamber tube part 2S, but these magnets (magnetic members) may be arranged inside the chamber tube part 2S (vacuum chamber 2). In Fig. 2, the distance between the central magnet 20 and the outer magnet 30 with respect to the target discharge surface 7S is indicated by L1 with reference to a rear surface part of the yoke plate 14. Furthermore, the yoke plate 14 is movable by a stroke L2 by a drive mechanism not illustrated. As a result, in accordance with wear of the surface of the target discharge surface 7S, the central magnet 20 and the outer magnet 30 can be moved rearward, and a stable magnetic field can be maintained.

### <Film Formation Treatment by Arc Discharge>

In Fig. 2, in a state where the vacuum pump 5 brings the internal space of the vacuum chamber 2 into a vacuum state and a predetermined coil current flows through the electromagnetic coil 8, when the arc power supply PS applies a discharge voltage between the main duct 10, the tip end duct 11, and the magnetic body 12 and the target 7, the target 7 functions as a cathode, and each of the main duct 10, the tip end duct 11, and the magnetic body 12 functions as an anode, and arc discharge occurs.

In the present embodiment, the magnetic force line (first magnetic force line) constituting the magnetic field (first magnetic field) formed by the electromagnetic coil 8 forward of the target discharge surface 7S has a forward-facing component. On the other hand, the magnetic force line (second magnetic force line) constituting the magnetic field (second magnetic field) formed on and around the target discharge surface 7S by the central magnet 20 arranged rearward of the target 7 has a rearward-facing component. That is, since the magnetic field formed by the electromagnetic coil 8 and the magnetic field formed by the central magnet 20 form a repulsive magnetic field therebetween, the magnetic force line passing through the target discharge surface 7S intersects the target discharge surface 7S at an acute angle on the center line CL side as indicated by an arrow D1 in Fig. 3. Therefore, on the target discharge surface 7S, a magnetic field component (horizontal magnetic field) parallel to the target discharge surface 7S and a magnetic field component (vertical magnetic field) perpendicular to the target discharge surface 7S stably coexist. In this case, the orientation of the component parallel to the center line CL in each magnetic force line formed on the target discharge surface 7S is the same (all forward in Figs. 2 and 3). In practice, the situation illustrated in Fig. 3 is distributed in a state of being rotated about the center line CL.

As described above, since the horizontal magnetic field is stably formed on the target discharge surface 7S, the moving speed of the arc spot is increased, and the arc spot can be prevented from remaining at the same place. As a result, a part of the target discharge surface 7S is suppressed from locally having a high temperature, and macroparticles that are droplets are suppressed from being generated, and the size thereof can be reduced. As a result, a large or large amount of macroparticles hardly reach the workpiece 4, and the surface roughness of the coating film on the workpiece 4 can be improved.

On the other hand, the electrons emitted from the target discharge surface 7S of the target 7 upon receiving the arc discharge fly from the target discharge surface 7S toward the workpiece 4 (Fig. 1) upon receiving the vertical magnetic field. Thereafter, most of the electrons preferentially reach the magnetic body 12 with the orientation changed to the radially outside as indicated by an arrow D2 in Fig. 3. As a result, the anode in the arc discharge is stably formed and retained in the magnetic body 12. Therefore, the position and size of the anode in the arc discharge are less likely to fluctuate, and an increase in the discharge voltage in the arc discharge can be suppressed. As mentioned earlier, since the main duct 10 and the tip end duct 11 also function as anodes in arc discharge, some of the electrons also reach these members. However, since the magnetic body 12 attracts the magnetic field formed by the electromagnetic coil 8, an anode can be formed exclusively on the magnetic body 12.

On the other hand, since the metal ions (cations) emitted from the target discharge surface 7S have a mass several thousand times that of the electrons, the metal ions cannot follow the electrons or the magnetic force line, and move toward the workpiece 4 radially inside the magnetic body 12 as indicated by the arrow DS, and are vapor-deposited on the workpiece 4. Therefore, even if electrons are attracted by the magnetic body 12 as described above in order to stabilize the arc discharge, it is possible to suppress a decrease in the film formation speed of metal ions with respect to the workpiece 4, that is, the productivity of the film formation treatment.

As described above, in the present embodiment, since the repulsive magnetic field is formed around the target discharge surface 7S by the first magnetic field of the electromagnetic coil 8 and the second magnetic field of the central magnet 20, the magnetic force line passing through the target discharge surface 7S can be forcibly tilted with respect to the center line CL by the repulsive magnetic field, and the vertical magnetic field and the horizontal magnetic field can stably coexist on the target discharge surface 7S. As a result, an arc spot can be actively moved on the target discharge surface 7S by the horizontal magnetic field, generation of macroparticles is suppressed, the number and size of the macroparticles can be reduced, and metal ions (film forming material) emitted from the target discharge surface 7S can stably fly toward the workpiece 4 by the vertical magnetic field.

In the present embodiment, since the outer magnet 30 having a reverse polarity is arranged around the central magnet 20, it is possible to suppress a decrease in the magnetic field intensity on the target discharge surface 7S due to the formation of the repulsive magnetic field as described above and to supplement the magnetic field intensity by the outer magnet 30. In particular, since the outer magnet 30 arranged radially outside the central magnet 20 can generate the third magnetic field containing the third magnetic force line in the same direction as the first magnetic force line of the first magnetic field, a magnetic field is formed outside the repulsive magnetic field as viewed from the center line CL so that the first magnetic force line and the third magnetic force line are continuous across the target discharge surface 7S. For this reason, the magnetic force line tilted against the center line CL by the repulsive magnetic field can be attracted to the outer magnet 30, the distribution (magnetic field) of the magnetic force line around the target discharge surface 7S can be suppressed from becoming unstable, and the magnetic field intensity on the target discharge surface 7S can be prevented from decreasing.

In the present embodiment, since the magnetic body 12 can attract a part of the first magnetic force line radially outward forward of the electromagnetic coil 8, the electrons emitted from the target discharge surface 7S can be preferentially guided to the magnetic body 12, and the anode in the arc discharge can be stably retained in the magnetic body 12. As a result, metal ions can be stably emitted from the target discharge surface 7S, and the metal ions can be stably supplied to the workpiece 4.

In particular, the magnetic body 12 has the magnetic inner peripheral surface 12A (inner peripheral surface) arranged radially inside relative to the electromagnetic coil 8 when viewed along the center line CL. Therefore, the magnetic force line (first magnetic force line) having passed through the inside of the electromagnetic coil 8 can be more strongly attracted radially outward at a position close to the center line CL.

Furthermore, in the present embodiment, since the tip end duct 11 or the like insulated from the vacuum chamber 2 functions as an anode, a discharge current does not flow in the vacuum chamber 2, and arc discharge can be stably maintained. In particular, the discharge space can be limited with the tip end duct 11 serving as an anode. As a result, since the behavior of the arc discharge is hardly affected by the state of the inside of the chamber (contamination of the chamber inner wall or arrangement of components), the film formation treatment can be stably performed with high reproducibility.

Furthermore, the main duct 10 and the tip end duct 11 of the duct 9 are arranged in a region between the target 7 and the magnetic body 12 so as to surround a passage region of the metal ions. Therefore, it is possible to collect the macroparticles emitted from the target 7 as indicated by an arrow D3, and it is possible to suppress the macroparticles from reaching the workpiece 4.

In particular, since the cylindrical duct 9 is arranged so as to straddle the chamber tube part 2S and the chamber body 2R, the metal ions emitted from the target discharge surface 7S can be stably guided toward the workpiece 4 accommodated in the chamber body 2R, and the generated macroparticles can be more reliably collected on the inner peripheral surface of the duct 9 before reaching the workpiece 4.

In the present embodiment, the main duct 10 is connected to the magnetic body 12 so as to be conductive to each other, and constitutes a part of the anode. Thus, since the main duct 10 functioning as an anode is arranged at a position closer to the target discharge surface 7S than the magnetic body 12, arc discharge can be generated between the main duct 10 and the target discharge surface 7S at the start of application of the discharge voltage, and initial discharge can be prevented from becoming unstable. Since the main duct 10 and the magnetic body 12 are conductive to each other, the anode in the arc discharge can be controlled in a range from the main duct 10 to the magnetic body 12 after the start of discharge. The position and range of the anode also change depending on the coil current (magnetic field intensity).

Furthermore, in the present embodiment, the introduction duct 13 is arranged between the target 7 and the main duct 10, and the introduction duct 13 is electrically insulated (floating) from the target 7 and the main duct 10. As a result, discharge with a certain distance between the cathode and the main duct 10 becomes possible, and occurrence of abnormal discharge can be suppressed by this insulation distance.

In the present embodiment, the main duct 10 and the tip end duct 11, which are arranged at positions closer to the target discharge surface 7S than the magnetic body 12, also function as anodes, whereby start of discharge between the target discharge surface 7S and the main duct 10 and the tip end duct 11 can be promoted at the start of discharge of arc discharge. Thereafter, as the discharge is stabilized, the magnetic body 12 further forward (downstream side) can function as a preferential anode. As described above, the main duct 10, the tip end duct 11, and the magnetic body 12 are sequentially arranged forward of the target discharge surface 7S across the insulated introduction duct 13, whereby the arc discharge can be stably maintained and the metal ions can stably reach the workpiece 4. As mentioned earlier, the position and range of the anode also change depending on the coil current (magnetic field intensity).

The arc evaporation source 6 and the film forming device 1 including the same according to each embodiment of the present invention have been described above. According to such the arc evaporation source 6, by promoting movement of the arc spot on the target discharge surface 7S, it is possible to suppress generation of macroparticles flying toward the workpiece 4, and to reduce the number and size of the macroparticles. The present invention is not limited to this embodiment. As the arc evaporation source 6 according to the present invention, the following modified embodiment is possible.
(1) In the above embodiment, a mode in which the vacuum chamber 2 has the chamber tube part 2S has been described, but the present invention is not limited to this mode. The vacuum chamber 2 may include a box shape so as to contain from the target 7 to the workpiece 4, or may further contain the central magnet 20 and the outer magnet 30.
(2) In the above embodiment, a mode in which the plurality of workpieces 4 are arranged on the rotary table 3, and the rotary table 3 rotates has been described, but the workpieces and their arrangement according to the present invention are not limited to such mode, and the workpieces may be arranged in the vacuum chamber 2 in another mode. The shapes of the workpiece 4, the target 7, and the like are not limited to those in the above mode. In particular, the target discharge surface 7S of the target 7 may have a rectangular shape, a polygonal shape, or the like orthogonal to the center line CL.
(3) The structure and number of the duct 9 are not limited to those in the above mode. The chamber tube part 2S of the vacuum chamber 2 may function as the main duct 10. In this case, the arc evaporation source 6 needs not include the duct 9.
(4) Furthermore, the structure of the anode of the arc evaporation source according to the present invention is not limited to that in the above mode. In place of the duct 9, another anode may be provided forward of the target discharge surface 7S. The main duct 10 needs not function as a part of the anode.
(5) In the above embodiment, a mode in which the magnetic force line (first magnetic force line) formed around the center line CL by the electromagnetic coil 8 extends forward, and, on the other hand, the magnetic force line (second magnetic force line) formed around the target discharge surface 7S by the central magnet 20 extends rearward has been described, but the orientations of them may be reversed. However, as in the above embodiment, it is desirable to set the orientation of each magnetic force line. In the relationship between the magnets, the N pole and the S pole may be opposite to each other.
(6) The arc evaporation source 6 needs not include the outer magnet 30 but may include only the central magnet 20. The arc evaporation source 6 needs not include the magnetic body 12. Also in this case, movement of the arc spot on the target discharge surface 7S can be promoted by the action of the magnetic field formed by each of the electromagnetic coil 8 and the central magnet 20.
(7) In the above embodiment, a mode in which the vacuum chamber 2 is provided with one arc evaporation source 6, but a plurality of the arc evaporation sources 6 may be arranged side by side. By providing a plurality of the chamber tube parts 2S and the arc evaporation sources 6 as illustrated in Fig. 2 above and below the chamber body 2R, it is possible to promote the film formation treatment for the workpiece 4. At this time, the magnetic body 12 in each of the arc evaporation sources 6 is arranged so as to enter the inside of the chamber body 2R from the chamber tube part 2S (so as to protrude into the chamber body 2R), whereby the magnetic fields of the adjacent arc evaporation sources 6 are prevented from interfering with each other. As a result, it is possible to prevent the orbit of the metal ion emitted from the target 7 of each of the arc evaporation sources 6 from being disturbed.

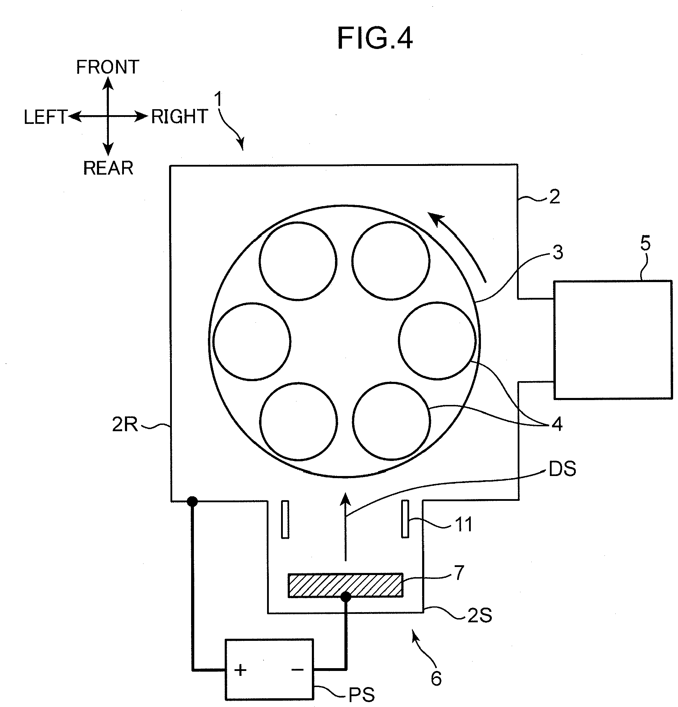

(8) Fig. 4 is a schematic horizontal cross-sectional view of the film forming device 1 including the arc evaporation source 6 according to a modified embodiment of the present invention. In the above embodiment, as illustrated in Fig. 1, a mode in which the positive electrode of the arc power supply PS is connected to the tip end duct 11 has been described, but a mode in which the positive electrode of the arc power supply PS is connected to the vacuum chamber 2 may be adopted. When the vacuum chamber 2 and the tip end duct 11 are connected so as to be conductive to each other, arc discharge occurs between the target 7 and the main duct 10, the tip end duct 11, and the magnetic body 12. In this case, since the vacuum chamber 2 can receive the discharge current of the arc discharge as a part of an anode, the functions of the main duct 10, the tip end duct 11, and the magnetic body 12 as the anode are complemented, and when the arc discharge becomes unstable, an excessive discharge current can be prevented from flowing through the main duct 10, the tip end duct 11, and the magnetic body 12, and damage thereof can be suppressed.

### Examples

Subsequently, specific examples of the present invention will be illustrated. The present invention is not limited to the following examples.

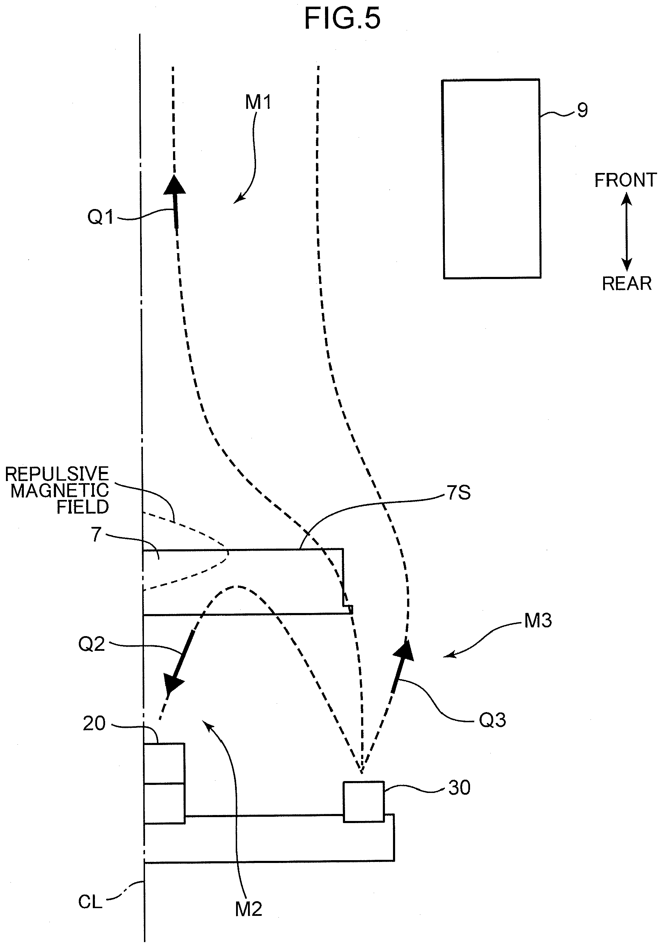

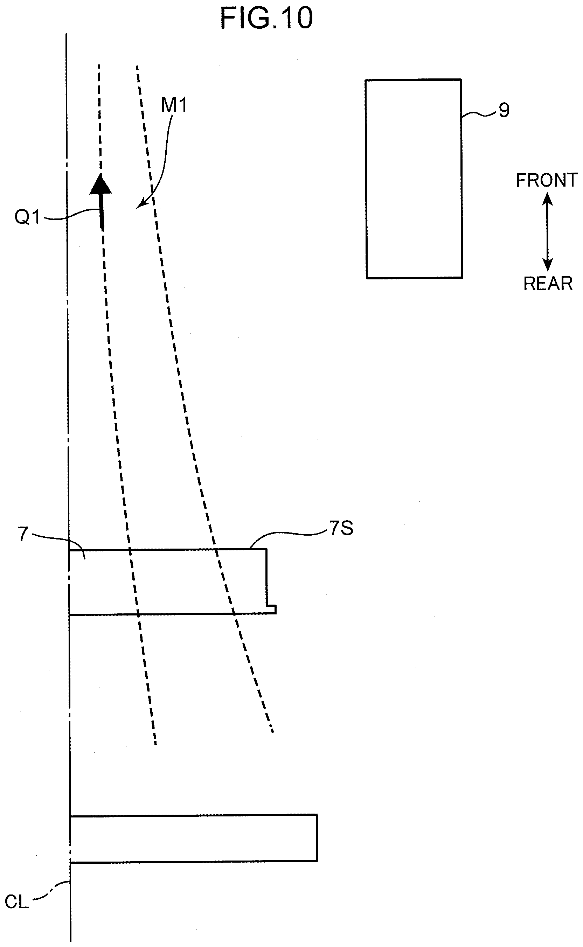

Figs. 5, 6, 7, 8, and 9 are views illustrating magnetic field distributions around a target in Example 1, Example 2, Example 3, Example 4, and Example 5, respectively, of the present invention. Figs. 10, 11, and 12 are views illustrating magnetic field distributions around a target in Comparative Example 1, Comparative Example 2, and Comparative Example 3, respectively, of the present invention. Those drawings are simplification of a situation of the magnetic field around the target discharge surface 7S visualized by a magnetic field analysis simulation.

### <Example 1>

In Example 1 illustrated in Fig. 5, the central magnet 20 and the outer magnet 30 are each arranged rearward of the target 7. In this case, the frontside of the central magnet 20 constitutes an S pole, and the frontside of the outer magnet 30 constitutes an N pole. As described in the above embodiment, the electromagnetic coil 8 (Fig. 2) forms a first magnetic field M1 on and forward of the target discharge surface 7S, and the central magnet 20 forms a second magnetic field M2 rearward of the target discharge surface 7S. The outer magnet 30 forms a third magnetic field M3 between the target 7 and the outer magnet 30.

A first magnetic force line Q1 contained in the first magnetic field M1 intersects the target discharge surface 7S and further pass through inside the duct 9 forward. A component of the first magnetic force line Q1 parallel to the center line CL extends forward. The polarity of the first magnetic field M1 (coil magnetic field) containing the first magnetic force line Q1 in such orientation is referred to as S pole. On the other hand, the second magnetic field M2 formed by the central magnet 20 contains a second magnetic force line Q2 extending rearward in a region between the central magnet 20 and the target 7 (a region surrounded by projecting the central magnet 20 onto the target 7 along a direction parallel to the center line CL). That is, the component of the second magnetic force line Q2 parallel to the center line CL is in a reverse orientation to the component of the first magnetic force line Q1 parallel to the center line CL. In the first magnetic force line Q1 and the second magnetic force line Q2, a component in a direction parallel to the center line CL is larger than a component in a direction perpendicular to the center line CL. In practice, the situation illustrated in Fig. 5 is distributed in a state of being rotated about the center line CL. The same applies to the drawings described later.

As a result, a repulsive magnetic field as illustrated in Fig. 5 is formed between the first magnetic field M1 and the second magnetic field M2. Therefore, by inclining the magnetic force line in the vicinity of the target discharge surface 7S so as to be pushed radially outward, the horizontal magnetic field and the vertical magnetic field as mentioned earlier are stably formed on the target discharge surface 7S. The magnetic force line passing through the target discharge surface 7S is inclined so as to spread radially outward from the electromagnetic coil 8 (Fig. 2) toward the central magnet 20.

Furthermore, in Example 1, the third magnetic field M3 formed by the outer magnet 30 contains a third magnetic force line Q3 extending forward between the target 7 and the outer magnet 30. That is, the component of the third magnetic force line Q3 parallel to the center line CL is in the same orientation as the component of the first magnetic force line Q1 parallel to the center line CL, and is in a reverse orientation to the component of the second magnetic force line Q2 parallel to the center line CL.

In this case, as described above, since the magnetic force line pushed radially outward around the target discharge surface 7S can extend so as to be continuous to the outer magnet 30, the stability of the magnetic field radially outside the target discharge surface 7S can be enhanced.

In the present invention represented by Example 1, as illustrated in Fig. 5, the closed magnetic field extending so as to connect the central magnet 20 and the outer magnet 30 remains rearward of the target discharge surface 7S and does not reach the target discharge surface 7S. In other words, as in a known magnetron technique, the orientations of the magnetic force lines formed on the target discharge surface 7S are not reversed in the front-rear direction. Therefore, the arc spot on the target discharge surface 7S is not significantly constrained and uneven wear of the target discharge surface 7S is not promoted, and stable discharge and emission of cations (film forming material) become possible.

### <Example 2>

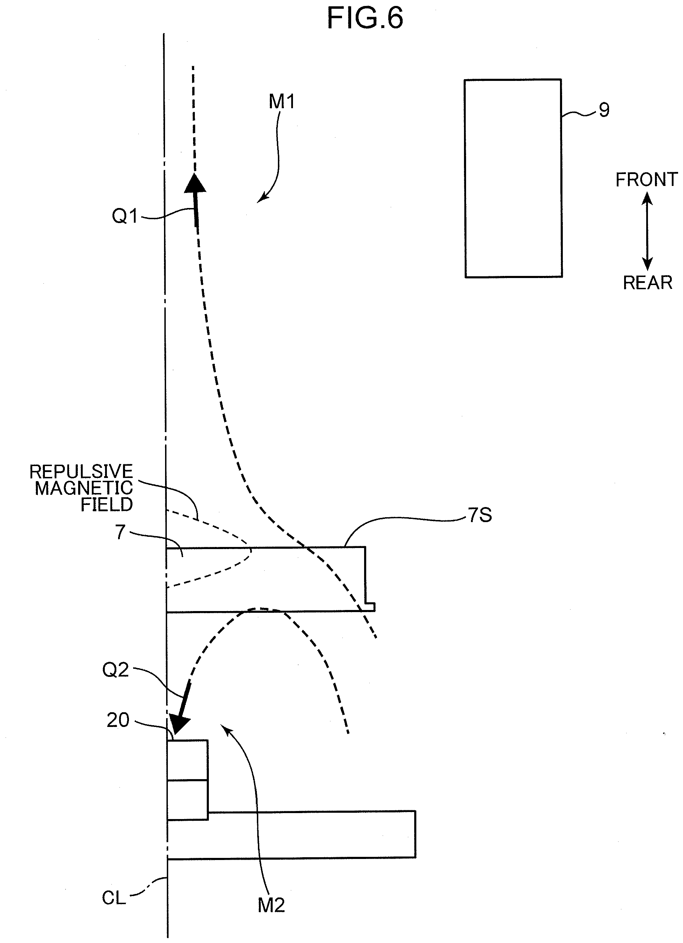

In Example 2 illustrated in Fig. 6, the central magnet 20 of an N pole is arranged rearward of the target 7, and, on the other hand, the outer magnet 30 as in Example 1 is not arranged. In this case, the first magnetic field M1 (coil magnetic field) of an S pole is formed by the electromagnetic coil 8 (Fig. 2) on and forward of the target discharge surface 7S, and the second magnetic field M2 is formed by the central magnet 20 rearward of the target discharge surface 7S.

Similarly to Example 1 described earlier, the component of the second magnetic force line Q2 parallel to the center line CL is in a reverse orientation to the component of the first magnetic force line Q1 parallel to the center line CL. As a result, a repulsive magnetic field as illustrated in Fig. 6 is formed between the first magnetic field M1 and the second magnetic field M2. Therefore, by inclining the magnetic force line in the vicinity of the target discharge surface 7S so as to be pushed radially outward, the horizontal magnetic field and the vertical magnetic field as mentioned earlier are stably formed on the target discharge surface 7S.

### <Examples 3 and 4>

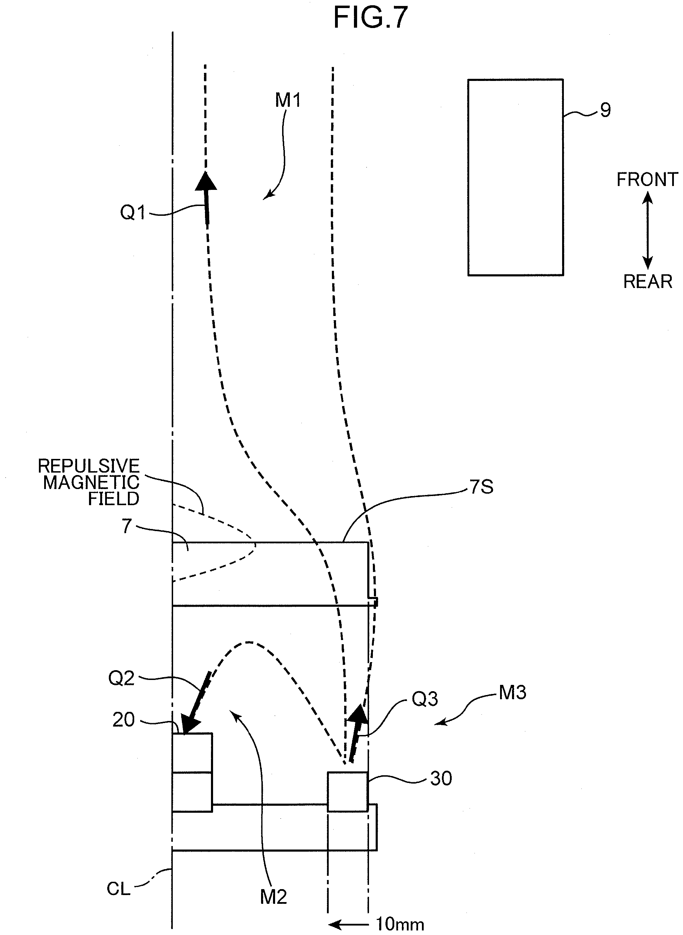

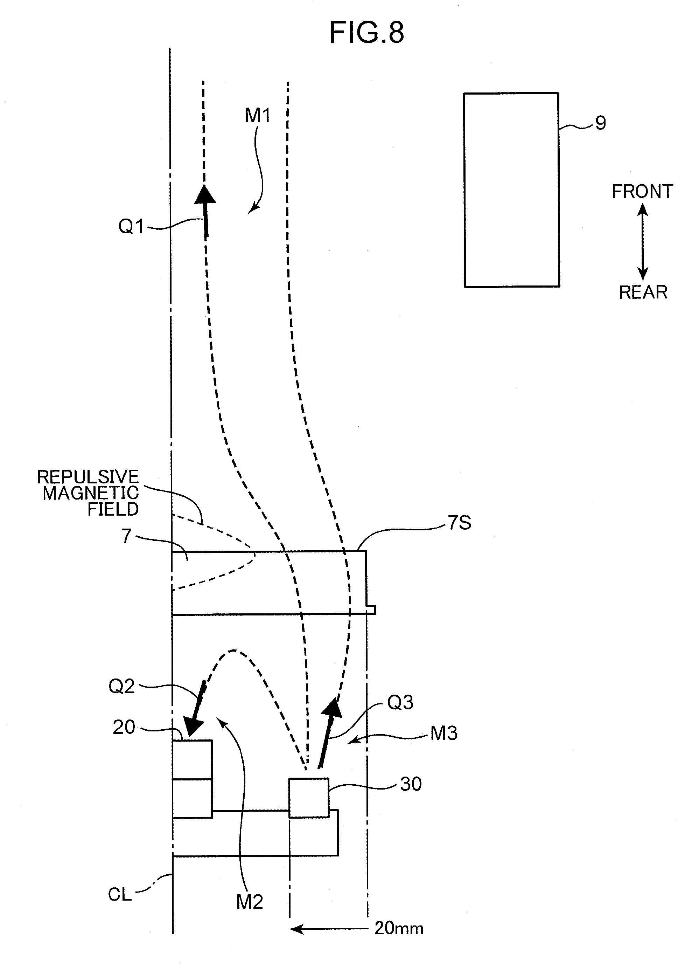

Example 3 illustrated in Fig. 7 corresponds to a state in which the outer magnet 30 is moved radially inward by 10 mm as compared with Example 1 described earlier. Similarly, Example 4 illustrated in Fig. 8 corresponds to a state in which the outer magnet 30 is moved radially inward by 20 mm as compared with Example 1 described earlier. Similarly, the frontside of the central magnet 20 constitutes an S pole, and the frontside of the outer magnet 30 constitutes an N pole. In Example 1, the radially outside surface of the target 7 and the radially inside surface of the outer magnet 30 are arranged on the same straight line parallel to the center line CL. Even in a case where the outer magnet 30 is arranged radially inside relative to the radially outside surface of the target 7 as in Examples 3 and 4, a repulsive magnetic field can be formed in a center part of the target discharge surface 7S, and the magnetic force line passing through the target discharge surface 7S can be set so as to intersect the target discharge surface 7S at an acute angle. As a result, the horizontal magnetic field and the vertical magnetic field as mentioned earlier are stably formed on the target discharge surface 7S.

### <Example 5>

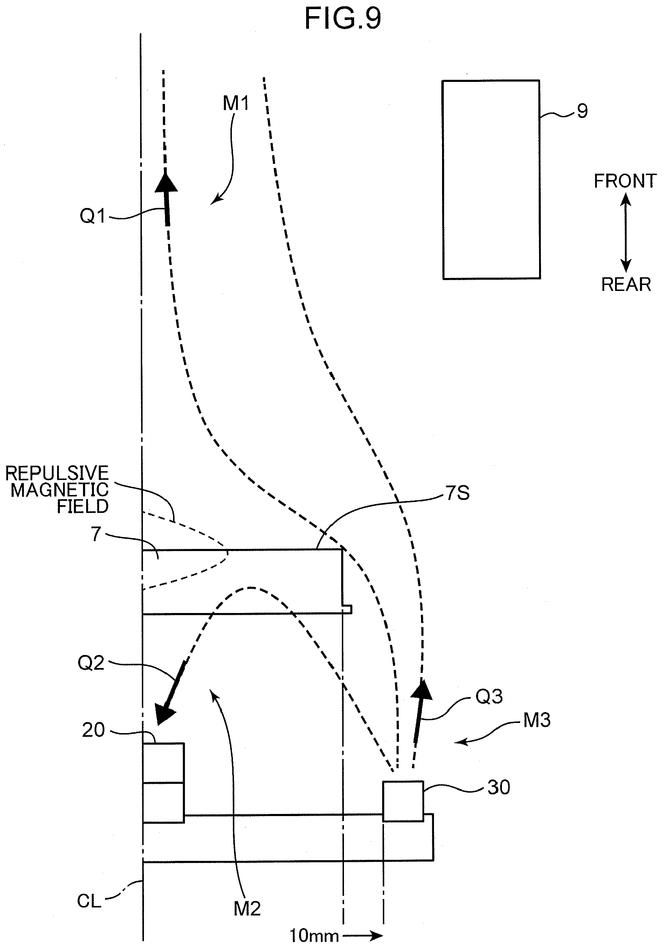

Example 5 illustrated in Fig. 9 corresponds to a state in which the outer magnet 30 is moved radially outward by 10 mm as compared with Example 1 described earlier. Even in a case where the outer magnet 30 is arranged radially outside relative to the radially outside surface of the target 7 in this manner, a repulsive magnetic field can be formed in a center part of the target discharge surface 7S, and the magnetic force line passing through the target discharge surface 7S can be set so as to intersect the target discharge surface 7S at an acute angle. As a result, the horizontal magnetic field and the vertical magnetic field as mentioned earlier are stably formed on the target discharge surface 7S.

In Examples 3, 4, and 5, generation of a horizontal magnetic field and a vertical magnetic field similar to those described above was confirmed even under a condition of not including the outer magnet 30. At this time, in order to stably fly, toward the workpiece 4, the charged particles emitted from the target discharge surface 7S while promoting movement of the arc spot, it is desirable that, regarding the radially inside surface of the outer magnet 30, the position radially inside by 20 mm relative to the radially outside surface of the target 7 is set as the lower limit, and the position radially outside by 20 mm relative to the radially outside surface of the target 7 is set as the upper limit. Regarding the radially inside surface of the outer magnet 30, it is more desirable that the same position in the radial direction as the radially outside surface of the target 7 is the lower limit, and the position radially outward by 20 mm relative to the radially outside surface of the target 7 is the upper limit. Beyond the above range, the horizontal magnetic field component on the target discharge surface 7S becomes weak, and therefore the performance may be relatively weakened depending on conditions of arc discharge and the like.

### <Comparative Example 1>

Comparative Example 1 illustrated in Fig. 10 is different from Example 1 described earlier in not including the central magnet 20 and the outer magnet 30. In this case, as illustrated in Fig. 10, since the first magnetic force line Q 1 containing only the vertical component exclusively is formed on the target discharge surface 7S, the movement of the arc spot cannot be promoted, and generation of macroparticles becomes remarkable.

### <Comparative Example 2>

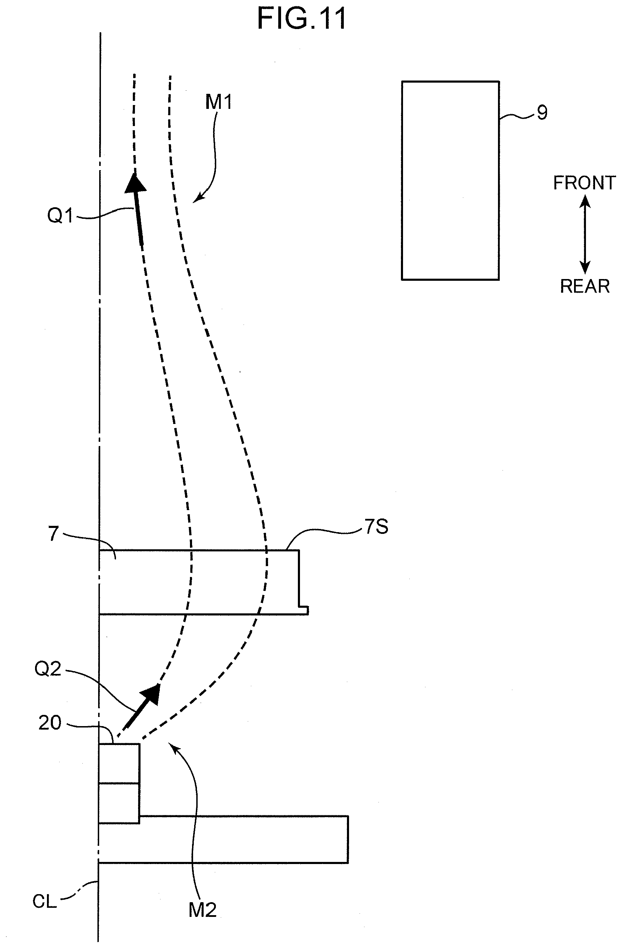

Comparative Example 2 illustrated in Fig. 11 is different from Example 1 described earlier in not including the outer magnet 30, and further, in that the first magnetic force line Q1 of the electromagnetic coil 8 and the second magnetic force line Q2 of the central magnet 20 have components in the same orientation (forward) as each other. Also in this case, as illustrated in Fig. 11, since the first magnetic force line Q1 containing only the vertical component exclusively is formed on the target discharge surface 7S, the movement of the arc spot cannot be promoted, and generation of macroparticles becomes remarkable.

### <Comparative Example 3>

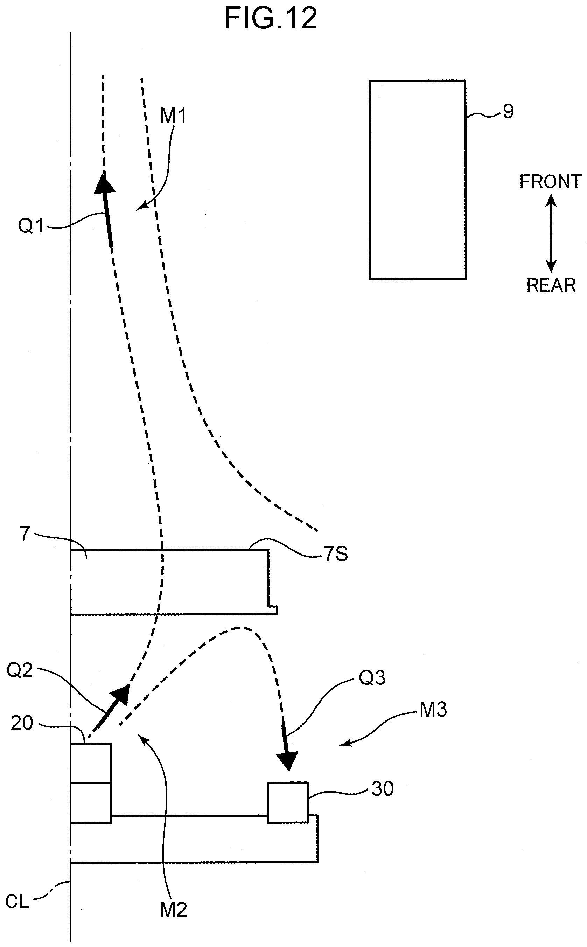

Comparative Example 3 illustrated in Fig. 12 is different from Example 1 described earlier in that, although having both the central magnet 20 and the outer magnet 30, the first magnetic force line Q1 and the second magnetic force line Q2 have components in the same orientation (forward) as each other similarly to Comparative Example 2. In this case, as illustrated in Fig. 12, a magnetic force line intersecting the target discharge surface 7S at an acute angle is slightly formed on the target discharge surface 7S, but a repulsive magnetic field is not formed in the center part of the target discharge surface 7S, and therefore the movement of the arc spot cannot be promoted, and it becomes difficult to suppress the number and size of macroparticles as compared with the above examples.

Provided by the present invention is an arc evaporation source that evaporates a film forming material by arc discharge and supplies the film forming material to a workpiece. The arc evaporation source includes a target, an anode, an arc power supply, an electromagnetic coil, and a central magnet. The target includes a target discharge surface arranged rearward of the workpiece and facing the workpiece, the target discharge surface emitting the film forming material forward upon receiving arc discharge. The anode is arranged forward of the target and generates the arc discharge. The arc power supply applies, between the target and the anode, a discharge voltage for generating the arc discharge. The electromagnetic coil is a cylindrical electromagnetic coil arranged forward of the target discharge surface and having a center line orthogonal to the target discharge surface. The electromagnetic coil forms a first magnetic field. The first magnetic field contains a first magnetic force line extending so as to pass through, in a front-rear direction, a cylindrical space intersecting the target discharge surface and surrounded by the electromagnetic coil. The central magnet is arranged on the center line rearward of the target discharge surface so as to form a second magnetic field. The second magnetic field contains the second magnetic force line extending in the front-rear direction in a region held between the central magnet and the target discharge surface in the front-rear direction. The central magnet forms the second magnetic field such that a component of the second magnetic force line parallel to the center line is in a reverse orientation to a component of the first magnetic force line parallel to the center line.

According to the present configuration, the first magnetic field of the electromagnetic coil and the second magnetic field of the central magnet form a repulsive magnetic field around the target discharge surface, and the repulsive magnetic field forcibly tilts the magnetic force line passing through the target discharge surface with respect to the center line, and this enables the vertical magnetic field and the horizontal magnetic field to stably coexist on the target discharge surface. As a result, an arc spot can be actively moved on the target discharge surface by the horizontal magnetic field, generation of macroparticles can be suppressed, and a film forming material emitted from the target discharge surface by the vertical magnetic field can stably fly toward the workpiece.

In the above configuration, it is preferable that the arc evaporation source further includes an outer magnet arranged radially outside the central magnet rearward of the target discharge surface and capable of forming a third magnetic field containing a third magnetic force line extending in the front-rear direction in a region forward of the outer magnet and rearward of the target discharge surface, in which the outer magnet forms the third magnetic field such that a component of the third magnetic force line parallel to the center line is in a same orientation as a component of the first magnetic force line parallel to the center line.

According to the present configuration, since the outer magnet arranged radially outside the central magnet can generate the third magnetic field containing the third magnetic force line in the same orientation as the first magnetic force line of the first magnetic field, it is possible to attract a magnetic force line tilted by the repulsive magnetic field to form a magnetic field in which the first magnetic force line and the third magnetic force line are continuous around the target discharge surface. Therefore, it is possible to suppress the magnetic field around the target discharge surface from becoming unstable due to the generation of the repulsive magnetic field, and to prevent the magnetic field intensity on the target discharge surface from decreasing.

In the above configuration, it is desirable to further include at least one duct arranged forward of the target discharge surface and radially inside relative to the electromagnetic coil and having a cylindrical shape about the center line, the at least one duct surrounding a duct internal space that receives the film forming material emitted from the target discharge surface and allows the film forming material to pass through toward the workpiece, in which the at least one duct includes a magnetic duct made of a conductive magnetic material and arranged forward of the electromagnetic coil so as to attract the first magnetic force line radially outward, and the magnetic duct constitutes at least a part of the anode.

According to the present configuration, since the magnetic duct can attract the first magnetic force line radially outward forward of the electromagnetic coil, electrons emitted from the target discharge surface can be preferentially guided to the magnetic duct, and the anode in the arc discharge can be stably retained in the magnetic duct.

In the above configuration, it is desirable that the magnetic duct includes a magnetic inner peripheral surface having an inner diameter smaller than an inner diameter of the electromagnetic coil and surrounding the duct internal space.

According to the present configuration, since the magnetic duct includes the magnetic inner peripheral surface arranged at a position close to the center line than the electromagnetic coil, the first magnetic force line having passed through inside the electromagnetic coil can be more strongly attracted radially outside.

In the above configuration, it is desirable to further include a vacuum chamber accommodating the workpiece and the target, in which the vacuum chamber is connected so as to be insulated from the at least one duct.

According to the present configuration, since the duct insulated from the vacuum chamber functions as an anode, the discharge current does not flow in the vacuum chamber, and the arc discharge can be stably maintained.

In the above configuration, it is preferable that the vacuum chamber includes a chamber body having a body space for accommodating the workpiece, and a chamber tubular part connected to the chamber body, extending tubularly about the center line, and having a tubular space communicating with the body space and accommodating the target, in which the at least one duct is arranged between the target and the workpiece so as to straddle the tubular space of the chamber tubular part and the body space of the chamber body.

According to the present configuration, since the cylindrical duct is arranged straddling the chamber tubular part and the chamber body, the film forming material emitted from the target discharge surface can be stably guided toward the workpiece accommodated in the chamber body, and the generated macroparticles can be more reliably collected on the inner peripheral surface of the duct before reaching the workpiece.

In the above configuration, it is desirable that the at least one duct further includes a main duct made of a conductive nonmagnetic material and arranged between the target discharge surface and the magnetic duct in the front-rear direction, and the main duct is connected to the magnetic duct so as to be conductive to each other, and constitutes a part of the anode.

According to the present configuration, since the main duct functioning as an anode is arranged at a position closer to the target discharge surface than the magnetic duct, arc discharge can be generated between the main duct and the target discharge surface at the start of application of the discharge voltage, and initial discharge can be prevented from becoming unstable. Since the main duct and the magnetic duct are conductive to each other, it is possible to control a range to be an anode in arc discharge in accordance with the coil current after the start of discharge.

According to the present invention, it is to provide an arc evaporation source that can suppress generation of macroparticles flying toward a workpiece by promoting movement of an arc spot on a target discharge surface.
An arc evaporation source includes a target including a target discharge surface, an arc power supply, an electromagnetic coil arranged forward of the target, and a central magnet arranged rearward of the target. The electromagnetic coil forms a first magnetic field containing a first magnetic force line intersecting the target discharge surface and extending so as to pass through, in a front-rear direction, radially inside the electromagnetic coil. The central magnet forms a second magnetic field containing a second magnetic force line extending in a front-rear direction in a region between the central magnet and the target discharge surface. Repulsion between the first magnetic field and the second magnetic field stably forms a horizontal magnetic field and a vertical magnetic field on the target discharge surface.

## Claims

1. An arc evaporation source that evaporates a film forming material by arc discharge and supplies a workpiece with the film forming material, the arc evaporation source comprising:
a target arranged rearward of the workpiece and facing the workpiece, the target including a target discharge surface that emits the film forming material forward upon receiving arc discharge;
an anode arranged forward of the target and generating the arc discharge;
an arc power supply that applies, between the target and the anode, a discharge voltage for generating the arc discharge;
an electromagnetic coil being a cylindrical electromagnetic coil, having a center line orthogonal to the target discharge surface and arranged forward of the target discharge surface so as to form a first magnetic field containing a first magnetic force line, the first magnetic force line being a magnetic force line intersecting the target discharge surface and extending so as to pass through, in a front-rear direction, a cylindrical space surrounded by the electromagnetic coil; and
a central magnet arranged on the center line rearward of the target discharge surface so as to form a second magnetic field containing a second magnetic force line, the second magnetic force line being a magnetic force line extending in a front-rear direction in a region held between the central magnet and the target discharge surface,
wherein
the central magnet forms the second magnetic field such that a component of the second magnetic force line parallel to the center line is in a reverse orientation to a component of the first magnetic force line parallel to the center line.

2. The arc evaporation source according to claim 1, further comprising:
an outer magnet arranged radially outside the central magnet rearward of the target discharge surface so as to form a third magnetic field containing a third magnetic force line, the third magnetic force line being a magnetic force line extending in a front-rear direction in a region forward of the outer magnet and rearward of the target discharge surface,
wherein
the outer magnet forms the third magnetic field such that a component of the third magnetic force line parallel to the center line is in a same orientation as a component of the first magnetic force line parallel to the center line.

3. The arc evaporation source according to claim 2, further comprising:
at least one duct arranged forward of the target discharge surface and radially inside the electromagnetic coil and having a cylindrical shape about the center line, the at least one duct surrounding a duct internal space that receives the film forming material emitted from the target discharge surface and allows the film forming material to pass through toward the workpiece,
wherein
the at least one duct includes a magnetic duct made of a conductive magnetic material and arranged forward of the electromagnetic coil so as to attract the first magnetic force line radially outward, and
the magnetic duct constitutes at least a part of the anode.

4. The arc evaporation source according to claim 3, wherein
the magnetic duct includes a magnetic inner peripheral surface having an inner diameter smaller than an inner diameter of the electromagnetic coil and surrounding the duct internal space.

5. The arc evaporation source according to claim 4, further comprising:
a vacuum chamber accommodating the workpiece and the target,
wherein
the vacuum chamber is connected to the at least one duct so as to be insulated from the at least one duct.

6. The arc evaporation source according to claim 5, wherein
the vacuum chamber includes:
a chamber body having a body space for accommodating the workpiece; and
a chamber tubular part connected to the chamber body, extending tubularly about the center line, and having a tubular space communicating with the body space and accommodating the target,
wherein
the at least one duct is arranged between the target and the workpiece so as to straddle the tubular space of the chamber tubular part and the body space of the chamber body.

7. The arc evaporation source according to claim 5 or 6, wherein
the at least one duct includes a main duct made of a conductive nonmagnetic material and arranged between the target discharge surface and the magnetic duct in a front-rear direction, and
the main duct is connected to the magnetic duct so as to be conductive to each other, and constitutes a part of the anode.
